# EUROPÄISCHE PATENTSCHRIFT

(11) **EP 0 474 085 B1**
(45) Veröffentlichungstag und Bekanntmachung des Hinweises auf die Patenterteilung: **02.08.1995**
(21) Anmeldenummer: 91114283.4
(22) Anmeldetag: 26.08.1991
(51) Int. Cl.: G01R 15/12

(54) **Multimeter zum wahlweisen Messen unterschiedlicher Messgrössen**
Multimeter for measuring different quantities at will
Multimètre pour mesurer différentes grandeurs selon le choix

(30) Priorität: 01.09.1990 DE 4027802
(43) Veröffentlichungstag der Anmeldung: 11.03.1992
(73) Patentinhaber: ABB PATENT GmbH, 68309 Mannheim (DE)
(72) Erfinder: Henkelmann, Dieter, W-8500 Nürnberg 50 (DE)
(74) Vertreter: Rupprecht, Klaus, Dipl.-Ing.

(56) Entgegenhaltungen:
- DE-A- 2 458 319
- GB-A- 870 627
- Funkschau 1970, Heft 20, Seite 2023 :"Normatest"; Schaltplan dazu

## Beschreibung

Die Erfindung betrifft ein Multimeter der im Oberbegriff des Anspruches 1 genannten Art.

Wegen ihrer vielseitigen Anwendbarkeit erfreuen sich Multimeter in Laboratorien und Werkstätten, aber auch bei Bastlern großer Beliebtheit. Je nach Ausstattung des Multimeters kann eine Vielzahl von Meßgrößen, wie Spannungen, Ströme, Widerstände, Pegel und Frequenzen, um nur einige zu nennen, mit einem einzigen Gerät gemessen werden. Das bedeutet jedoch, daß die Meßschaltungen, die zur Erfassung der verschiedenen Meßgrößen benötigt werden, sich zum Teil erheblich unterscheiden, so daß für die unterschiedlichen Meßgrößen auch unterschiedliche Eingangskreise des Multimeters zur Verfügung stehen müssen.

Es ist wichtig, daß vor jeder Messung der richtige, der zu untersuchenden Meßgröße zugeordnete Eingangskreis angeschlossen wird. Soll z. B. die Netzspannung gemessen werden und bleibt versehentlich der Eingangskreis eingeschaltet, der zur Messung von Strömen vorgesehen ist, so kann das für das Multimeter, bisweilen sogar für den Bedienenden, schwerwiegende Folgen haben, wenn die Netzsicherung nicht schnell genug abschaltet. Die im Multimeter vorgesehene Gerätesicherung reicht in aller Regel nicht aus, um das Multimeter von einer energiereichen Spannungsgquelle zu trennen, da der beim Öffnen des Stromkreises auftretende Lichtbogen die Gerätesicherung überbrücken kann.

Ähnliche Probleme und Gefahren können auch bei anderen Kombinationen, bei denen eine Meßgröße auf einen falschen Eingangskreis trifft, für das Meßobjekt, das Multimeter und den Bedienenden entstehen. Doch selbst dann, wenn aus einem Bedienungsfehler keine unmittelbare Gefahr resultiert, kann es immer noch zu einer mittelbaren Gefährdung kommen, wenn z.B. die Anzeige des Multimeters das Fehlen einer zu prüfenden Spannung vortäuscht, weil ein Eingangskreis angeschlossen wurde, der gerade außer Betrieb, also nicht mit dem Meßsystem verbunden war. Durch die vorgetäuschte Spannungsfreiheit wird der Bedienende bisweilen zu ihn gefährdenden Handlungen verleitet.

Worauf zu achten ist, damit es bei einem Multimeter nicht zu derartigen Fehlbedienungen kommt, hängt vom Aufbau dieses Gerätes ab. Bei vielen Multimetern besitzen die verschiedenen Eingangskreise einen allen Eingangskreisen gemeinsamen ersten Eingangsanschluß und einen eigenen dem jeweiligen Meßkreis zugeordneten mit der zugehörigen Meßgröße korrespondierenden zweiten Eingangsanschluß. In der Regel gehören zu jeder Meßgröße wiederum mehrere Meßbereiche z.B. zur Meßgröße "Spannung" die Meßbereiche 1, 3, 10, 30V usw. Der Eingangskreis besitzt in diesem Fall einen Spannungsteiler, an dem alle Spannungen auf Werte herabgeteilt oder auch durch Verstärkung erhöht werden, damit an das Meßsystem angepaßte Werte zur Verfügung stehen.

Für das Umschalten des Spannungsteilers auf einen gewünschten Spannungsmeßbereich bzw. das Umschalten von Shunts auf einen gewünschten Strommeßbereich verwendet man einen Meßbereichsschalter. Bei der Bedienung des Meßgerätes muß man also dafür sorgen, daß der Meßbereichsschalter auf die Meßgröße gestellt wird, die gemessen werden soll. Gleichzeitig ist aber darauf zu achten, daß eingangsseitig am Multimeter die Meßleitungen mit den richtigen Eingangsanschlüssen und dadurch mit dem richtigen Eingangskreis verbunden werden.

Es liegt auf der Hand, daß bei weniger konzentriertem Arbeiten, besonders auch durch Nichtfachleute, einer der beiden Bedienhandgriffe vergessen werden kann und dann entweder der falsche Eingangskreis angeschlossen, oder ein falscher Meßbereich eingeschaltet wird.

Selbstverständlich hat man versucht mit zusätzlichen Sicherungsmaßnahmen die Gefahren einer Fehlbedienung in Grenzen zu halten. Die verwendeten Schutzschaltungen arbeiten mit passiven und aktiven Schaltern, Relaisschaltern, gesteuerten Halbleiterschaltern, mit Transistoren und Thyristoren sowie Schmelzsicherungen besonderer Bauart. Trotz des teilweise recht hohen Aufwandes gelingt es mit bisherigen Techniken jedoch keineswegs immer, leistungsstarke Spannungsquellen innerhalb des kleinen, bei modernen Multimetern zur Verfügung stehenden Raumes im Fehlerfall sicher abzuschalten. Eine Verminderung der Gefahren läßt sich somit nur erzielen, wenn die Fehlbedienung weitgehend ausgeschlossen wird.

Es wurde versucht diese Aufgabe dadurch zu lösen, daß man das Umstecken der Meßleitungen durch Umschalten der Eingangskreise ersetzte. Hierdurch wurde zwar die Bedienung des Meßgerätes etwas erleichtert, aber das Problem nicht beseitigt. So kann das Umschalten der Eingangskreise entweder durch einer zusätzlichen Eingangskreisschalter geschehen oder durch den Meßbereichsschalter zusätzlich übernommen werden. Ein zusätzlicher Eingangskreisschalter verlagert das Problem lediglich auf ein anderes Bauteil, da nun mit gleicher Aufmerksamkeit darauf geachtet werden muß, daß sowohl der Eingangskreisschalter als auch der Meßbereichsschalter auf die zu untersuchende Meßgröße gestellt wurden. Demgegenüber bedeutet eine Zusammenfassung aller Schaltfunktionen am Meßbereichsschalter, daß dieser in der Lage sein muß außer sehr kleinen auch große Leistungen zu schalten, was wiederum eine erhebliche Verteuerung dieses Bauelements zu Folge hat. Außerdem ist zu bedenken, das die hierdurch erreichte Verminderung der Zahl der Bedienelemente nicht zwangsläufig die Bedienung wesentlich sicherer macht, denn auch ein einziger Schalter kann immer noch in eine falsche Schaltstellung gebracht werden, was dann zwangsläufig zum Anschluß auch eines falschen Eingangskreises mit entsprechenden Folgen führt. Insofern kann der Zwang auf die richtige Stellung von zwei Bedienelementen achten zu müssen, zu einer erhöhten Aufmerksamkeit führen.

Bekannt ist in diesem Zusammenhang aus "Funkschau 1970, Heft 20, Seite 2023", ein Multimeter mit dem Namen "NORMATEST", das zwei Schalter besitzt, die zur Messung im Meßbereich 12mV beide auf diesen Meßbereich gestellt werden müssen, damit ein Strom zum Meßwerk des Multimeters fließen kann. Die nicht miteinander gekoppelten Schalter können jedoch unabhängig voneinander in jede ihrer Schaltstellungen gebracht werden, so daß kein Schutz für die Eingangskreise des Multimeters mit den Vor- und Nebenwiderständen erreicht wird und daß es außerdem zu einer Unterbrechung des Meßstromkreises und einer daraus resultierenden Fehlmessung kommen kann.

Aufgabe der Erfindung ist es, ein Multimeter nach dem Oberbegriff des Anspruchs 1 zu schaffen, das mit einem Meßbereichsschalter auskommt, der nur sehr kleine Leistungen zur Weitergabe an das Meßsystem schalten muß, und das Risiko, daß es zu einer Fehlbedienung des Meßgerätes kommt, vermindert.

Diese Aufgabe wird durch die im Anspruch 1 gekennzeichneten Merkmale gelöst. Zweckmäßige Ausgestaltungen und Weiterbildungen des Erfindungsgegenstandes sind in den Unteransprüchen genannt.

Erfindungsgemäß soll das Multimeter mindestens einen Eingangskreisschalter besitzen, der unabhängig von der mit Hilfe des Meßbereichsschalters getroffenen Meßgrößenvorgabe zusätzlich ein- oder umgeschaltet werden muß, damit das angelegte Meßsignal in den der vorgegebenen Meßgröße zugehörigen Eingangskreis gelangt. Dies scheint der Lösung, daß eine Kopplung zwischen dem Eingangskreisschalter und dem Meßbereichsschalter bestehen soll, zu widersprechen. Entscheidend ist jedoch, daß die Kopplungsvorrichtung nicht starr ist, sondern nur soweit gehen darf, daß sichergestellt ist, daß der jeweilige Eingangskreis nur eingeschaltet werden kann, wenn die ihm zugeordnete Meßgröße mit der am Meßbereichsschalter vorgegebenen Meßgröße übereinstimmt. Obwohl es sich also um eine genau definierte Kopplung handelt, ermöglicht diese ein separtes Ein- oder Umschalten des Eingangskreisschalters einerseits und des Meßbereichsschalters andererseits. Der Benutzer des Multimeters wird hierdurch zur erhöhten Aufmerksamkeit gezwungen, da er zwei Schalter in eine Schaltstellung bringen muß, die der von ihm gewünschten Meßgröße entsprechen. Nur wenn beide Schalter auf die falsche Meßgröße gestellt werden und noch dazu auf die gleiche falsche Meßgröße, kann es zu einer Gefährdung des Multimeters kommen. Die Wahrscheinlichkeit hierfür ist jedoch wesentlich geringer, als bei üblichen Multimetern, da der Benutzer nunmehr zwei Fehler, ja sogar zwei gleiche Fehler machen müßte, was relativ unwahrscheinlich ist. Solange er nur einen der beiden Schalter falsch einstellt, besteht durch die Kopplung der beiden Schalter keine Übereinstimmung und der eingestellte Eingangskreis des Multimeters wird nicht eingeschaltet.

Ziel einer Weiterbildung des Erfindungsgegenstandes ist, zu verhindern, daß nach einer richtigen Wahl des Meßbereiches durch den Meßbereichsschalter und den Eingangskreisschalter bewußt oder unbewußt der Meßbereichsschalter umgeschaltet wird, und diese Fehlbedienung zu einer Gefährdung des Multimeters führt. Es ist deshalb weiterhin eine Arretiervorrichtung vorgesehen, die ein Umschalten auf eine andere Meßgröße nur nach Lösen der Arretierung ermöglicht.

Baut man die Arretiervorrichtung mit mechanischen Bauelementen auf, so wird man ein erstes Arretierelement vorzugsweise als Arretierzapfen ausbilden, so daß dieses dann in ein zweites Arretierelement, vorzugsweise eine Arretiernut eingreifen kann, wobei letztere an einem beweglichen, das Umschalten ermöglichenden Teil des jeweiligen Schalters ausgebildet ist und so ein Umschalten auf eine unzulässige Meßgröße verhindert. Bei einem von Hand zu betätigenden Eingangskreisschalter kann man diesen im Aktionsbereich eines beweglichen Teiles des Meßbereichsschalters, vorzugsweise eines zu diesem gehörigen Schaltrades montieren, und die beiden Schalter so miteinander koppeln, daß das erste Arretierelement am beweglichen Teil des Eingangskreisschalters ausgebildet ist, und dieses an einem zweiten an einem beweglichen Teil des Meßbereichsschalters ausgebildeten Arretierelement einen Eingriff findet.

Um die Unabhängigkeit der beiden Schalter voneinander zu gewährleisten, darf ein solcher Eingriff allerdings nur durch entsprechende Betätigung des Benutzers herbeigeführt werden. Hierzu ist es vorteilhaft, den Eingangskreisschalter als kombinierten Dreh- und Druckschalter zu gestalten, der durch Drehen mindestens zwei unterschiedliche Grundstellungen einnehmen kann, in denen er bei einer Druckbetätigung jeweils einen bestimmten Eingangskreis einschaltet. Das erste Arretierelement kann dabei von der Grundstellung des Eingangskreisschalters aus in verschiedene, der Meßgröße zugeordnete zweite Arretierelemente, vorzugsweise Nuten im beweglichen Teil des Meßbereichsschalters eindringen. Die Arretierung sorgt nunmehr dafür, daß ein Verstellen der Schalter zu einer anderen Meßgröße nur bei ausgeschaltetem Eingangskreisschalter möglich ist.

Da eine Kopplung zwischen den beiden Schaltern nur solange besteht, solange die Arretierelemente ineinandergreifen, wirken letztere bei dieser Ausführungsform des Eingangskreisschalters auch als Kopplungselemente, so daß bei gelöster Arretierung auch keine Kopplung mehr besteht. Zweckmäßigerweise ist die Lage oder Art der ersten Arretierelemente zur Lage oder Art der zweiten Arretierelemente so codiert, daß ein gegenseitiger Eingriff und damit ein Einschalten des Eingangskreisschalters nur möglich ist, wenn beide Schalter auf die gleiche Meßgröße gestellt sind, bei eingeschaltetem Eingangskreisschalter aber nicht umgeschaltet werden kann. Dies kann man mit mindestens einem als Zapfen ausgebildeten exzentrisch angeordneten ersten Arretierelement erreichen, das für eine beim Drehen des Eingangskreisschalters entsprechend wechselnde Positionierung sorgt und dem als Nuten ausgebildete zweite Arretierelemente so gegenüberstehen, daß nur bei übereinstimmender Stellung der Zapfen in die zugehörige Nut eingreifen kann.

Die Kopplungsvorrichtung läßt sich auch mit Hilfe von elektrischen Schaltkreisen aufbauen. So kann man den Meßbereichsschalter mit mindestens einer zusätzlichen Schaltstrecke ausrüsten, über die mindestens ein Hilfskreis geführt ist, derart, daß sich bei eingeschaltetem Hilfskreis eine feste von der Schaltstellung des Meßbereichsschalters abhängige Zuordnung zu einem bestimmten Eingangskreis und damit zu einer bestimmten Meßgröße ergibt. In den Hilfskreis kann man mindestens einen Funktionsgeber einfügen, der bei Betätigung durch Schließen des Hilfsstromkreises aktiviert wird. Es hängt wesentlich von der Art des Funktionsgebers und der Ausgestaltung der Hilfskreise ab, welcher Schutz mit der Schaltung erzielbar ist.

Zweckmäßig ist es, jeder Meßgröße einen Hilfskreisschalter zuzuordnen, dessen Schaltstellung mit der Schaltstellung des Eingangskreisschalters fest gekoppelt ist.

Mit einem als Umschalter oder Einschalter wirkenden Eingangskreisschalter kann eine Schutzschaltung sowohl für Multimeter mit gemeinsamen Eingangsanschlüssen für alle Eingangskreise als auch für Multimeter mit mehreren den verschiedenen Eingangskreisen spezifischen Eingangsanschlüssen aufgebaut werden. Bei einem Multimeter mit mehreren Eingangsanschlüssen ist es vorteilhaft, in mindestens einen Eingangsanschluß einen Kontaktgeber zu integrieren, dessen Kontaktstrecke in mindestens einem Hilfskreis liegt. Der Kontaktgeber ist dabei so auszuführen, daß er beim Anschließen einer Meßleitung kontaktiert und dadurch den jeweiligen Hilfskreis schließt. Wird ein solcher Hilfskreis auch in Abhängigkeit von der Stellung des Meßbereichsschalters ein- oder ausgeschaltet, und aktiviert er einen Funktionsgeber, der in diesem Fall ein Signalgeber sein kann, so ist es möglich, ein optisches oder akustisches Warnsignal abzugeben, wenn mit den Meßleitungen ein Eingangskreis verbunden wird, dem eine andere Meßgröße als die am Meßbereichsschalter eingestellte Meßgröße zugeordnet ist. Ein gegebenenfalls in einem zweiten Hilfskreis liegender zweiter Funktionsgeber kann als Magnetsteller ausgebildet sein und zur Betätigung des Eingangskreisschalters dienen.

Eine Schaltkreiskopplung über bestimmte Schaltstrecken des Meßbereichsschalters sorgt dafür, daß mindestens ein Eingangskreis nur eingeschaltet werden kann, wenn die diesem Eingangskreis zugeordnete Meßgröße mit der am Meßbereichsschalter eingestellten Meßgröße übereinstimmt.

Es ist vorteilhaft, den als Magnetsteller wirkenden zweiten Funktionsgeber mit einem bistabilen Schaltverhalten auszustatten, derart, daß durch Ein- und Ausschaltimpulse ein Stellungswechsel herbeiführbar ist. Bei entsprechendem mechanischem Aufbau kann der Magnetsteller außer dem Eingangskreisschalter und einem Hilfskreisschalter auch ein Arretierelement betätigen. Die Auslösung des Arretierelementes kann selbstverständlich auch durch einen zweiten Magnetsteller erfolgen. Wesentlich ist, daß das Arretierelement nur aktiviert wird, wenn die am Meßbereichsschalter eingeschaltete Meßgröße mit der dem Eingangsanschluß zugeordneten Meßgröße übereinstimmt, also der Eingangskreisschalter mit dem zugeordneten Anschluß korreliert.

Ausführungsbeispiele der Erfindung sind in den Zeichnungen dargestellt und werden im folgenden näher beschrieben.

Es zeigen:
- Fig. 1: Prinzipschaltbild zur Sperrung bestimmter Eingangskreise bei einem Multimeter mit mehreren Eingangsanschlüssen und gesteuerten Eingangskreisschaltern,
- Fig. 2: Prinzipschaltbild zur Sperrung bestimmter Eingangskreise bei einem Multimeter mit zwei gemeinsamen Eingangsanschlüssen und handbetätigbarem Eingangskreisschalter,
- Fig. 3: Meßbereichsschalter und handbetätigter Eingangskreisschalter in Draufsicht auf die Deckplatte des Multimeters,
- Fig. 4: mechanische Kopplung zwischen Meßbereichs- und Eingangskreisschalter in Draufsicht,
- Fig. 5: mechanische Kopplung zwischen Meßbereichs- und Eingangskreisschalter in Seitenansicht in entkoppelter Stellung,
- Fig. 6: mechanische Kopplung zwischen Meßbereichs- und Eingangskreisschalter in Seitenansicht in gekoppelter Stellung,
- Fig. 7: Prinzipschaltbild zur Sperrung bestimmter Eingangskreise bei einem Multimeter mit zwei gemeinsamen Eingangsanschlüssen und gesteuerten Eingangskreisschaltern.

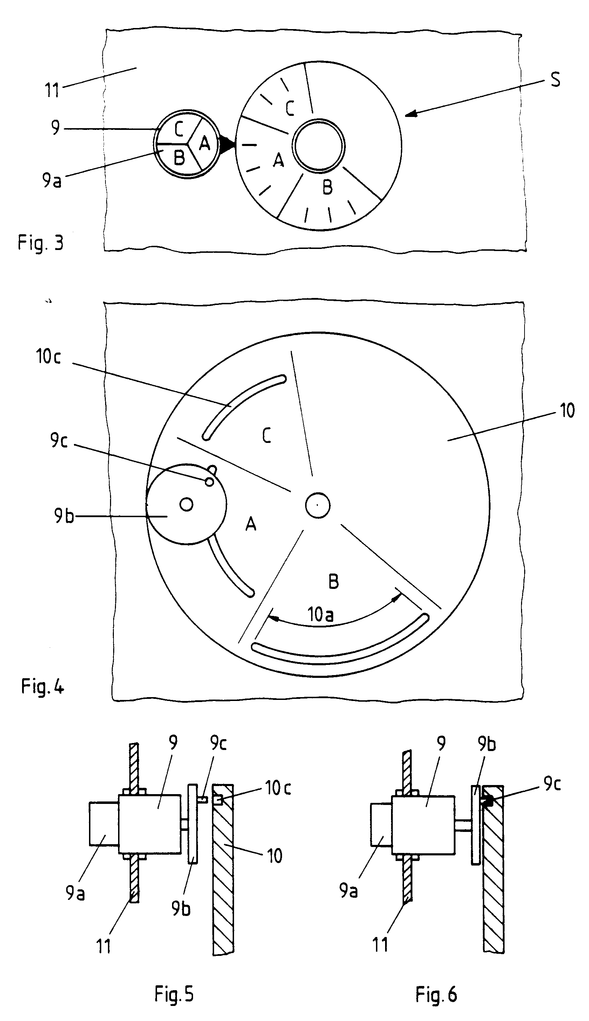

Eine rein mechanische Kopplung zwischen einem Meßbereichsschalter S und einem Eingangskreisschalter 9 ist in den Figuren 3 bis 6 dargestellt. Wie Fig. 3 zeigt sind die beiden Schalter in unmittelbarer räumlicher Nähe zueinander angeordnet und zwar derart, daß die auf ihrem Bedienknopf aufgebrachte Beschriftung für die Meßgrößen A bis C in eine zueinander korrespondierende Stellung gebracht werden kann. Als Bezugsmarke dient ein zwischen den beiden Bedienknöpfen auf der Deckplatte 11 des Multimeters aufgebrachter Pfeil 13. Beide Bedienknöpfe sind somit in eine Schalterstellung zu bringen, in der der Pfeil 13 auf die gleiche Meßgröße weist. Im vorliegenden Beispiel sind beide Schalter auf die Meßgröße A eingestellt. Beim Meßbereichsschalter S sind den drei Meßgrößen A bis C noch jeweils mehrere Meßbereiche zugeordnet. Die Kopplung zwischen den beiden Schaltern soll so wirken, daß der Eingangskreisschalter nur eingeschaltet werden kann, wenn der Pfeil 13 bei beiden Schaltern auf die gleiche Meßgröße weist. Ein Umschalten des Meßbereichsschalters S zwischen verschiedenen Meßbereichen der gleichen Meßgröße A/B oder C soll jedoch trotz Arretierung möglich sein.

Die Fig. 4 bis 6 verdeutlichen eine Möglichkeit zur Realisierung der Kopplung. Ein zum Meßbereichsschalter S gehöriges und von diesem angetriebenes radartiges Schalterelement 10 ist mit einem so großen Durchmesser versehen, daß es bis in den Aktionsbereich des Eingangskreisschalters 9 reicht. Der Eingangskreisschalter 9 ist als Dreh-Druck-Schalter aufgebaut, der ein Dreh-Druckelement 9a besitzt, das zunächst durch Drehung in eine Schaltstellung gebracht werden muß, in der ein Eingangskreis des Multimeters vorgewählt wird, der zur Aufnahme der nunmehr am Pfeil 13 liegenden Meßgröße, in diesem Fall die Meßgröße A, geeignet ist. Ein Einschalten des vorgewählten Eingangskreises wird jedoch erst herbeigeführt, wenn es gelingt, das Dreh-Druckelement 9a durch Druck in seine Einschaltstellung zu bringen. Dies ist jedoch nur erreichbar, wenn ein mit dem Dreh-Druckelement 9a verbundenes scheibenartiges Kopplungselement 9b, das mit einem exzentrisch an ihm befestigten ersten Arretierelement 9c versehen ist, in ein zweites als Arretiernut ausgebildetes Arretierelement 10c des Schalterelements 10 eingreifen kann.

Durch die exzentrische Anordnung des als Arretierzapfen ausgebildeten ersten Arretierelementes 9c ändert sich dessen Lage zum Schalterelement 10 des Meßbereichsschalters S mit jeder Drehung des Drehdruckelementes 9a zum Einstellen einer anderen Meßgröße A bis C. Die als zweites Arretierelement 10c im Schalterelement 10 des Meßbereichsschalters ausgebildeten Arretiernuten sind nun jeweils so positioniert, daß der Arretierzapfen 9c nur dann in sie eindringen kann, wenn beide Schalter auf die gleiche Meßgröße A bis C gestellt wurden.

Da die Arretierung lediglich ein Umschalten des Meßbereichsschalters zwischen den verschiedenen Meßgrößen A bis C bei eingeschaltetem Eingangskreisschalter 9 verhindern soll, ist innerhalb des Arretierungsbereichs 10a einer Meßgröße ein Umschalten zwischen verschiedenen Meßbereichen dieser Meßgröße möglich.

Der beschriebene Aufbau mit zwei getrennten Schaltern hat den Vorteil, daß die gegebenenfalls großen Ströme in bestimmten Eingangskreisen nicht mit Hilfe des Meßbereichsschalters geschaltet werden müssen. Es ist einfacher einen mit relativ wenigen Kontakten versehenen Eingangskreisschalter so zu gestalten, daß er auch große Ströme beherrscht. Darüberhinaus ist eine Gefährdung des Eingangskreisschalters beim Umschalten nicht möglich, da vor dem Umschalten immer erst der Stromkreis unterbrochen wird. Weiterhin ist der Benutzer zu erhöhter Aufmerksamkeit gezwungen, wenn er jeweils zwei Schalter in die richtige Stellung bringen muß und er müßte bei der Einstellung der Schalter mindestens zwei Fehler machen, nämlich bei beiden Schaltern die gleiche falsche Meßgröße einstellen, bevor es zu einem Fehlerfall kommt.

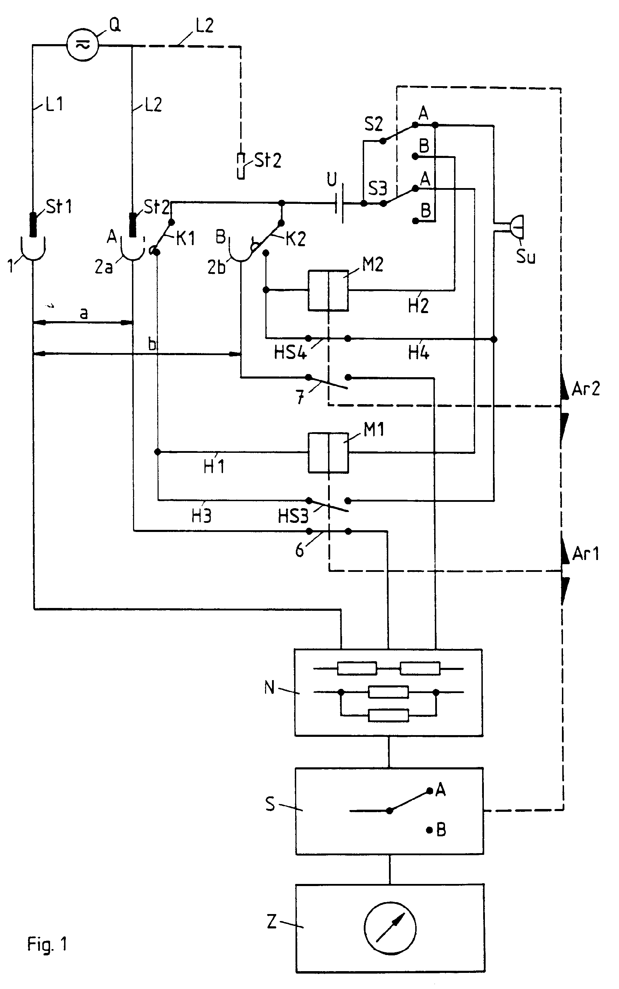

Die weiteren Beispiele zum Aufbau einer Schutzvorrichtung nach den Figuren 1,2 und 7 zeigen elektrische Schaltungen, bei denen die Schutzfunktion weitgehend durch elektrische bzw. elektromechanische Bauelemente erreicht wird. Die zur Arretierung des Meßbereichsschalters benötigten mechanischen Bauelemente können, soweit es die Codierung der verschiedenen Meßbereiche betrifft, dem in Fig. 4 dargestellten Prinzip entsprechen.

Das in Fig. 1 dargestellte Prinzipschaltbild zeigt ein Meßobjekt Q, z.B. eine Spannungsquelle, das über die Meßleitungen L1, L2 und Stecker ST1,ST2 mit Eingangsanschlüssen 1,2 des Multimeters verbunden ist. Das Multimeter besitzt zwei Eingangskreise a,b mit einem für beide gemeinsamen Eingangsanschluß 1 und spezifischen, den jeweiligen Eingangskreisen zugeordneten Eingangsanschlüssen 2a,2b. Der unterschiedliche Aufbau der Eingangskreise a, b soll durch das Meßbereichsnetzwerk N verdeutlicht werden, das z.B. aus Spannungsteilerwiderständen zur Spannungsumschaltung oder Shunts zur Stromumschaltung bestehen kann, und bei dem die Umschaltung durch einen Meßbereichsschalter S erfolgt. Das entsprechend angepaßte Meßsignal gelangt anschließend zu einem Meßsystem Z, das zur Messung und Anzeige dient.

Zwischen den Eingangsanschlüssen 2a,2b, denen jeweils die Meßgrößen A,B zugeordnet sind, und der diesen Meßgrößen zugeordneten Schaltstellung des Meßbereichsschalter S besteht ein Zusammenhang derart, daß die Meßleitung L2 unbedingt mit dem richtigen Eingangsanschluß 2a, 2b verbunden werden muß.

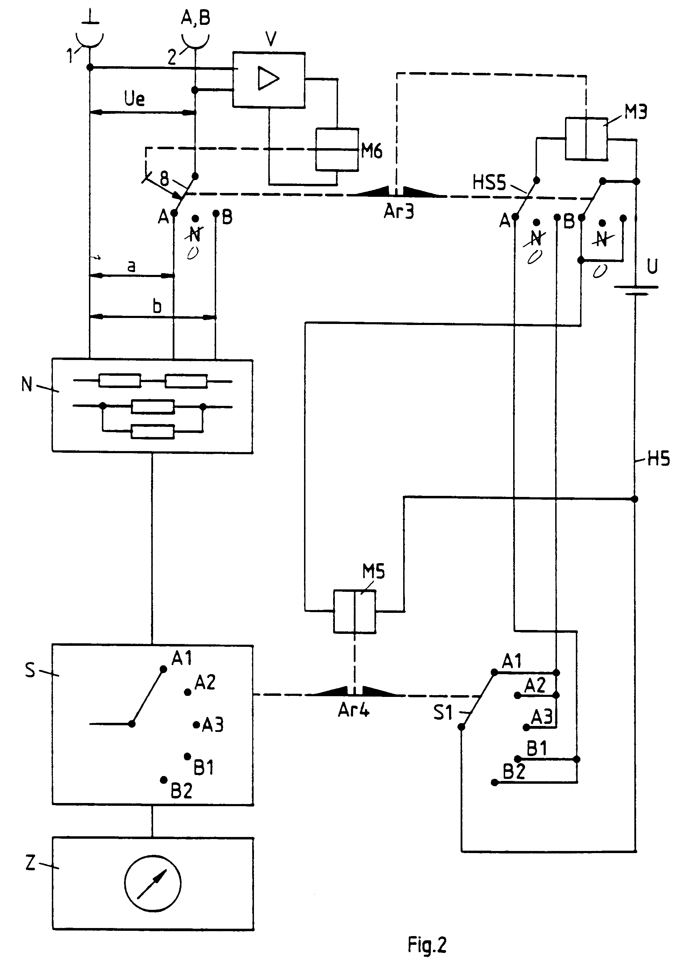

Das in Fig. 2 dargestellte Prinzipschaltbild entspricht soweit es den Multimeteraufbau betrifft, im wesentlichen dem in Fig. 1, unterscheidet sich aber dadurch, daß anstelle mehrerer spezifischer Eingangsanschlüsse 2a,2b für alle Eingangskreise a,b gemeinsame Eingangsanschlüsse 1,2 vorgesehen sind, so daß ein Umstecken von Meßleitungen L1,L2 entfällt. Als Ersatz für das Umstecken wurde ein Eingangskreisschalter 8 in die Schaltung eingefügt, der ausgehend von einer Nullstellung 0 auf eine Meßgröße A oder B und damit auf die Eingangskreise a,b umgeschaltet werden kann.

Ein zum Eingangskreisschalter 8 gehöriger oder mit diesem mechanisch gekoppelter Hilfskreisschalter HS5 wird ebenfalls ausgehend von einer Nullstellung 0 auf eine der Meßgröße A oder B zugeordnete Schaltstellung umgeschaltet. Zusammen mit einem in Reihe geschalteten Magnetsteller M3, einer Spannungsquelle U und einer Schaltstrecke S1 des Meßbereichschalters S liegt er in einem Hilfskreis H5.

Der Meßbereichsschalter S erlaubt ein Umschalten zwischen den Meßgrößen A und B einerseits sowie zwischen verschiedenen Meßbereichen A1,A2,A3 der Meßgröße A und B1,B2 der Meßgröße B. Die von der Stellung des Meßbereichsschalters S abhängige Stellung der Schaltstrecke S1 ist mit dem Hilfskreisschalter HS5 so verbunden, daß der Magnetsteller M3 und die von ihm abhängige Arretierung Ar3 aktiviert wird, sobald der Hilfskreisschalter S5 auf eine andere Meßgroße geschaltet wird als die durch den Meßbereichsschalter S vorgegebene Meßgröße. Der Hilfskreisschalter HS5 ist dabei so ausgelegt, daß er bei dem Schaltvorgang dem Eingangskreisschalter 8 vorauseilt und beim Umschalten auf eine falsche Meßgröße die Arretierung Ar3 noch in einer Weise wirksam wird, daß sie ein Umschalten des Eingangskreisschalters auf eine falsche Meßgröße verhindert.

Bei den in Fig. 2 dargestellten Schaltstellungen stimmt die am Meßbereichsschalter S eingestellte Meßgröße A mit der am Eingangskreisschalter 8 eingestellten Meßgröße überein. Sollte jedoch versucht werden, den Eingangskreisschalter 8 auf die Meßgröße B umzuschalten, so würde über den voreilenden Hilfskreisschalter HS 5 der Magnetsteller M3 und damit die Arretierung Ar3 in einer Weise aktiviert, daß der Eingangskreisschalter 8 wieder in die Nullstellung 0 zurückgeschaltet werden müßte.

Die beschriebene Wirkungsweise der Schaltung gewährleistet, daß nach Vorgabe einer Meßgröße durch den Meßbereichsschalter S, nur der Eingangskreis a,b eingeschaltet werden kann, dem die gleiche Meßgröße zugeordnet ist. Darüberhinaus soll jedoch sichergestellt sein, daß bei eingeschaltetem Eingangskreisschalter 8 und damit geschlossenem Eingangskreis a oder b der Meßbereichschalter S nicht auf eine andere Meßgröße umgeschaltet werden kann. Dies läßt sich mit Hilfe einer zweiten Schaltstrecke des Hilfskreisschalters HS5 erreichen, die in gleicher Weise, wie seine erste Schaltstrecke eine Nullstellung 0 besitzt, von der ausgehend auf eine der Meßgrößen A,B geschaltet werden kann. Über diese zweite Schaltstrecke wird ein weiterer Magnetsteller M5 mit Hilfe der Spannungsquelle U des Hilfskreises H5 gesteuert. Durch die Arretierung Ar4 sorgt er dafür, daß der Meßbereichsschalter S nur umgeschaltet werden kann, wenn sich der Eingangskreisschalter 8 in Nullstellung 0 befindet. Dem Benutzer des Multimeter ist es somit nicht möglich, aus Versehen bei eingeschaltetem Eigangskreisschalter den Meßbereichsschalter S auf eine andere Meßgröße umzuschalten.

Trotz der getroffenen Maßnahmen zur Erhöhung der Bedienungssicherheit des Multimeters verbleibt die Möglichkeit, daß vor Inbetriebnahme des Multimeters bereits eine Meßgröße eingestellt wurde, die für das zu messende Meßsignal ungeeignet ist. Um den Benutzer vor dem Anschließen eines neuen Meßobjektes zur Überprüfung der Multimetereinstellung zu zwingen, ist ein weiterer Magnetsteller M6 vorgesehen, der mit Hilfe eines Verstärkers V das Meßsignal Uₑ überwacht, und bei dessen Wegfall eine Rückstellung des Eingangskreisschalters 8 in seine Nullstellung 0 bewirkt.

Bei dem Prinzipschaltbild nach Fig. 1 handelt es sich, wie bereits erläutert, um ein Multimeter mit mehreren Eingangsanschlüssen 1,2a,2b. Soweit er das Multimeter betrifft, stimmen die beiden Schaltbilder nach Fig. 1 und 2 weitgehend überein, was auch durch gleiche Bezugszeichen verdeutlicht wird. Soweit jedoch die Schutzschaltung betroffen ist, ergeben sich Unterschiede dadurch, daß nach Fig. 1 die Unterbrechung oder Freigabe der Eingangskreise a,b durch gesteuerte Eingangskreisschalter 6,7 herbeigeführt wird. Die Betätigung der Eingangskreisschalter erfolgt wiederum in Abhängigkeit von der Schaltstellung des Meßbereichsschalters S derart, daß nur der Eingangskreisschalter 6,7 eingeschaltet wird, der in einem Eingangskreis a,b liegt, dem die am Meßbereichsschalter S eingestellte Meßgröße entspricht. Erreicht wird das mit zwei zum Meßbereichsschalter S gehörigen Schaltstrecken S2,S3, die zusammen mit je einem Magnetsteller M1,M2 in einem Hilfskreis H1,H2 liegen und zur Steuerung des jeweiligen Eingangskreisschalters 6,7 dienen.

Wesentlich für die Funktion der Schutzschaltung ist, daß zwischen dem Meßbereichsschalter S bzw. seinen Schaltstrecken S2,S3 keine starre Kopplung zu den Eingangskreisschaltern 6,7 besteht, derart, daß die den Meßgrößen A,B zugeordneten Eingangskreise a,b zwangsweise eingeschaltet würden, sondern daß das Einschalten der Eingangskreisschalter 6,7 von einer weiteren Bedingung abhängt. Diese weitere Bedingung wird mit Hilfe von Kontaktgebern K1,K2 geschaffen, von denen jeweils einer elektrisch den Eingangskreisen H1,H2 und mechanisch den als Steckbuchsen ausgebildeten Eingangsanschlüssen 2a,2b zugeordnet ist. Die Kontaktgeber K1,K2 sind so in die Eingansanschlüsse 2a,2b integriert, daß sie sich nur beim Einstecken eines Steckers ST2 schließen, z.B. indem der Stecker ST2 auf einen isolierenden Nocken des Kontaktgebers K1,K2 trifft, und diesen dabei soweit verdrängt, daß sich der Kontakt schließt. Bevor somit in den Hilfkreisen H1,H2 ein Strom fließen kann, der zu einer Aktivierung des Magnetstellers M1,M2 führen würde, muß gewährleistet sein, daß der Stecker ST2 dem Eingangsanschluß 2a,2b kontaktiert hat, der für eine Eingangsgröße A,B vorgesehen ist, die zuvor bereits durch den Meßbereichsschalter S vorgegeben wurde.

Wie in dem Beispiel nach Fig. 1 dargestellt, kann der Magnetsteller M1 den Eingangskreischalter 6 nur einschalten, wenn der ihn aktivierende Hilfstromkreis H1 beim Kontaktieren des Eingangsanschlusses 2a durch den Kontaktgeber K1 geschlossen wird und die Schaltstrecke S3 sich wie der Meßbereichsschalter S in einer der Meßgröße A entsprechenden Stellung befindet. Hierdurch ist sichergestellt, daß ein Eingangsstrom nur in einem solchen Eingangskreis a, b fließen kann, der für die am Meßbereichsschalter S vorgegebene Meßgröße vorgesehen ist.

Die anhand des Beispiels in Fig. 1 beschriebenen Maßnahmen schließen jedoch die Möglichkeit nicht aus, den Stecker ST2 mit dem Eingangsanschluß 2b zu verbinden. Hierdurch würde zwar nicht der Eingangskreis b gefährdet, da die Schaltstrecke S2 geöffnet bleibt und der Magnetsteller M2 nicht zum Schließen des Eingangskreisschalters 7 aktiviert wird, dem Meßsystem Z würde jedoch das Fehlen eines Eingangssignals vorgetäuscht, was den Benutzer zu entsprechenden Fehlhandlungen verleiten könnte. Es wurden deshalb weitere Hilfskreis H3,H4 gebildet, die einerseits in Abhängigkeit von der Stellung des Magnetstellers M1,M2 und andererseits in Abhängigkeit von der Stellung des Kontaktgebers K1,K2 über die Schaltstrecken S2,S3 einen Signalgeber Su, vorzugsweise einen akustischen Signalgeber, mit der Spannungsquelle U verbinden. Die Hilfskreise H3,H4 sind demnach so aufgebaut, daß der Signalgeber Su immer dann aktiviert wird, wenn ein Eingangsanschluß 2a,2b kontaktiert wird, dem eine Meßgröße zugeordnet ist, die nicht der am Meßbereichsschalter S eingestellten Meßgröße entspricht. Der Benutzer wird hierdurch zum Umstecken des Steckers S2 veranlaßt.

Eine weitere Gefahr besteht darin, daß bei richtig angeschlossener Meßleitung L2 und dementsprechend geschlossenem Eingangskreisschalter 6,7 der Meßbereichsschalter S bewußt oder versehentlich auf eine andere Meßgröße umgeschaltet wird. Die zuvor beschriebenen Sicherungsmaßnahmen würden zwar greifen, d.h. der Signalgeber Su würde aktiviert, und der Eingangskreisschalter des betroffenen Eingangskreises geöffnet, doch gerade letzteres ist unerwünscht, zumindest solange im Eingangskreis z.B. ein hoher Strom fließt, da in diesem Fall die Unterbrechung des Stromkreises die Kontakte des Eingangskreisschalters gefährden könnte. Um dieser Gefahr vorzubeugen, ist eine dem Magnetsteller M1 zugeordnete Arretierung Ar1 und eine dem Magnetsteller M2 zugeordnete Arretierung Ar2 vorgesehen. Die beiden Arretierungen Ar1 und Ar2 könnten auch zusammengefaßt werden, da sie beide auf den Meßbereichsschalter S einwirken und diesen solange arretieren, solange einer der beiden Eingangskreischalter 6,7 eingeschaltet ist. Das bedeutet, daß der Meßbereichsschalter S nur umgeschaltet werden kann, wenn der Stecker ST2, zum Umstecken in einen anderen Eingangsanschluß, aus dem momentan kontaktierten Eingangsanschluß 2a,2b entfernt wird. Hierdurch ist gewährleistet, daß der Eingangskreisschalter 6,7 sich nur bei stromlosem Eingangskreis öffnet.

Auf Details, wie eine Arretierung des Meßbereichsschalters durchgeführt werden kann, soll hier nicht näher eingegangen werden, da sich eine große Zahl naheliegender Lösungsmöglichkeiten anbietet. Wesentlich ist jedoch, daß die Arretierung so ausgebildet wird, daß zwar nicht von einer Meßgröße auf eine andere Meßgröße umgeschaltet werden kann, wohl aber innerhalb verschiedener Meßbereiche derselben Meßgröße. Dies ist durch eine entsprechend codierte Mechanik ohne Schwierigkeiten erreichbar.

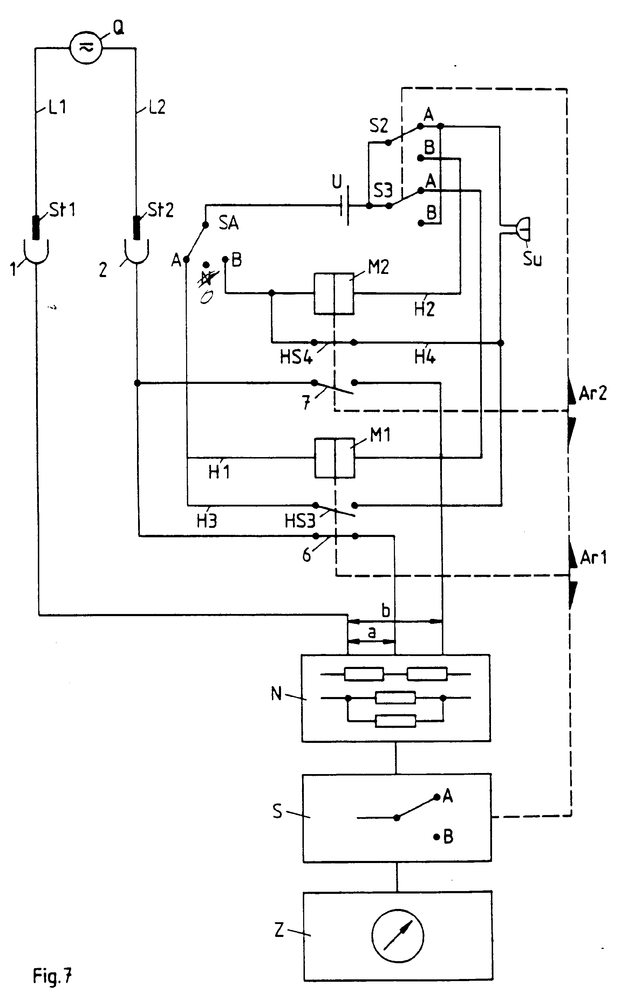

Die Benutzer von Multimetern empfinden das Umstecken der Meßleitung L2 in einen anderen Eingangsanschluß bei einem Wechsel der Meßgröße oft als lästig. Sie bevorzugen in der Regel Schalter zum Umschalten, die das Umstecken ersparen. Der Aufbau einer entsprechenden Schaltung analog zu der Schaltung nach Fig. 1 ist ohne Schwierigkeiten möglich. Wie Fig. 7 zeigt ist an die Stelle der beiden Eingangsanschlüsse 2a,2b ein gemeinsamer Eingangsanschluß 2 getreten, was ohne weiteres zulässig ist, da die Eingangskreisschalter 6,7 ein getrenntes Einschalten der Eingangskreise a,b erlauben. Der von der Schaltung nach Fig. 1 auf den Benutzer ausgeübte Zwang zu erhöhter Aufmerksamkeit, indem er sowohl bei Betätigung des Meßbereichsschalters S wie auch beim Kontaktieren der Meßleitung L2 auf die richtige Meßgröße A,B achten muß, kann in entsprechender Weise auch mit einem Hilfsschalter SA erreicht werden. Dieser tritt quasi an die Stelle der Kontaktgeber K1,K2 nach Fig. 3 und muß sich wie der Meßbereichsschalter S in einer einer bestimmten Meßgröße A,B zugeordneten Schaltstellung befinden.

## Patentansprüche

1. Multimeter zum wahlweisen Messen unterschiedlicher Meßgrößen (A, B), deren Meßsignale über verschiedene, jeweils einer bestimmten Meßgröße (A, B) zugeordnete Eingangskreise (a, b) vom Multimeter erfaßt werden und bei dem die Vorgabe einer bestimmten Meßgröße (A, B) mit Hilfe eines Meßbereichsschalters (S) erfolgt und in mindestens einen der Eingangskreise (a, b) ein Eingangskreisschalter (6 bis 9) eingefügt ist, der unabhängig von der mit Hilfe des Meßbereichsschalters (S) getroffenen Meßgrößenvorgabe zusätzlich ein- oder umgeschaltet werden muß, damit das angelegte Meßsignal in den der vorgebenen Meßgröße (A, B) zugehörigen Eingangskreis (a, b) gelangt, dadurch gekennzeichnet, daß eine nicht starre Kopplungsvorrichtung (H, H1, H2, 9b, 10b) zwischen dem Eingangskreisschalter (6 bis 9) und dem Meßbereichsschalter (S) dafür sorgt, daß der Eingangskreisschalter (6 bis 9) nur in eine solche Einschaltstellung gebracht werden kann, die bezüglich der vom zugehörigen Eingangskreis (a, b) vorgebenen Meßgröße (A, B) mit der am Meßbereichsschalter (S) eingestellten Meßgröße (A, B) übereinstimmt.

2. Multimeter nach Anspruch 1, dadurch gekennzeichnet, daß mindestens eine der Schaltstellungen des Eingangskreisschalters (6-9) und/oder des Meßbereichsschalters (S) derart arretiert wird, daß ein Umschalten auf eine andere Meßgröße (A,B) nur durch Lösen einer Arretiervorrichtung (9c,10c,Ar1-Ar4) möglich ist.

3. Multimeter nach Anspruch 2, dadurch gekennzeichnet, daß die Arretiervorrichtung mit mechanischen Bauelementen aufgebaut ist, von denen ein erstes Arretierelement (9c), vorzugsweise ein Arretierzapfen, in ein zweites Arretierelement (10c), vorzugsweise eine Arretiernut, an einem beweglichen, das Umschalten ermöglichenden Teil (10) des jeweiligen Schalters (S,9) eingreift und so ein Umschalten auf eine unzulässige Meßgröße (A,B) verhindert.

4. Multimeter nach mindestens einem der vorhergehenden Ansprüche, dadurch gekennzeichnet, daß der Eingangskreisschalter (9) als Eingangskreishandschalter ausgebildet ist und dieser im Aktionsbereich eines beweglichen Teiles (10) des Meßbereichsschalters (S), vorzugsweise eines Schalterrades (10) liegt, und am beweglichen Teil (9a) des Eingangskreishandschalters (9) das erste Arretierelement (9c) ausgebildet ist, das an einem zweiten, am beweglichen Teil (10) des Meßbereichsschalters (S) ausgebildeten Arretierelement (10c) einen Eingriff ermöglicht.

5. Multimeter nach Anspruch 3, dadurch gekennzeichnet, daß der Eingangskreishandschalter (9) als kombinierter Dreh- und Druckschalter gestaltet ist, der durch Drehen mindestens zwei unterschiedliche Grundstellungen einnehmen kann, in denen er bei einer Druckbetätigung jeweils einen bestimmten Eingangskreis (a,b) einschaltet, und das Arretierelement (9c) von der Grundstellung des Eingangskreisschalters (9) aus in verschiedene der Meßgröße (A, B) zugeordnete zweite Arretierelemente (10c), vorzugsweise Arretiernuten, im beweglichen Teil (10) des Meßbereichsschalters (S) eindringen kann, derart, daß ein Verstellen der Schalter (S,9) auf eine andere Meßgröße nur bei ausgeschaltetem Eingangskreisschalter (9) möglich ist.

6. Multimeter nach Anspruch 3, dadurch gekennzeichnet, daß das erste und zweite Arretierelement (9c,10c) auch als Kopplungselemente wirken und bei gelöster Arretierung auch keine Kopplung mehr besteht und die Lage oder Art der ersten Arretierelemente (9c) zur Lage oder Art der zweiten Arretierelemente so kodiert ist, daß ein gegenseitiger Eingriff und damit ein Einschalten des Eingangskreisschalters nur möglich ist, wenn beide Schalter (S,9) auf die gleiche Meßgröße (A,B) gestellt sind, bei eingeschaltetem Eingangskreisschalter (9) aber nicht umgeschaltet werden kann, vorzugsweise, indem mindestens ein als Zapfen ausgebildetes, exzentrisch angeordnetes erstes Arretierelement (9c) für eine von der Meßgröße (A,B,C) abhängige wechselnde Positionierung sorgt, und diesen als Nuten ausgebildete zweite Arretierelemente (10c) so gegenüberstehen, daß nur bei übereinstimmender Stellung der Zapfen in die zugehörige Nut eingreifen kann.

7. Multimeter nach Anspruch 1 oder 2, dadurch gekennzeichnet, daß die Kopplungsvorrichtung mit elektrischen Schaltkreisen aufgebaut ist und der Meßbereichsschalter (S) mindestens eine Schaltstrecke (S1-S3) besitzt, über die mindestens ein Hilfskreis (H1-H5) geführt ist, derart, daß sich bei eingeschaltetem Hilfskreis (H1-H5) eine feste, von der Schaltstellung des Meßbereichschalters (S) abhängige Zuordnung zu einem bestimmten Eingangskreis (a,b) und damit zu einer bestimmten Meßgröße (A,B) ergibt und in dem Hilfskreis (H1-H5) mindestens ein Funktionsgeber (M1-M4,Su) liegt, der bei Betätigung durch Schließen des Hilfsstromkreises (H1-H5) aktiviert wird.

8. Multimeter nach Anspruch 7, dadurch gekennzeichnet, daß jeder Meßgröße (A,B) ein Hilfskreisschalter (HS3-HS5) zugeordnet ist, dessen Schaltstellung mit der Schaltstellung des Eingangskreisschalters (6-8) gekoppelt ist.

9. Multimeter nach mindestens einem der vorhergehenden Ansprüche, dadurch gekennzeichnet, daß verschiedene Eingangskreise (a,b) über mindestens einen als Umschalter oder Einschalter wirkenden Eingangskreisschalter (8) auf zwei, mehreren Meßgrößen (A,B) gemeinsame Eingangsanschlüsse (1,2) geführt sind oder daß verschiedene Eingangskreise (a,b) mit verschiedenen Eingangsanschlüssen (2a,2b) verbunden sind, die jeweils bestimmten Meßgrößen (A,B) entsprechen und in mindestens einen der Eingangskreise (a,b) ein als Um- oder Einschalter wirkender Eingangskreisschalter (6,7) eingefügt ist.

10. Multimeter nach Anspruch 9, dadurch gekennzeichnet, daß in mindestens einen Eingangsanschluß (2a,2b) ein Kontaktgeber (K1,K2) integriert ist, dessen Kontaktstrecke in mindestens einem Hilfskreis (H1-H4) liegt und der beim Anschließen einer Meßleitung (L2) kontaktiert und dadurch den jeweiligen Hilfskreis (H1-H4) schließt.

11. Multimeter nach mindestens einem der vorhergehenden Ansprüche, dadurch gekennzeichnet, daß ein erster Funktionsgeber als Signalgeber (Su) wirkt, der ein optisches oder akustisches Warnsignal abgibt, wenn ein Eingangskreis (a,b) angeschlossen wird, dem eine andere Meßgröße (A,B) als die am Meßbereichsschalter (S) eingestellte Meßgröße (A,B) zugeordnet ist.

12. Multimeter nach Anspruch 7, dadurch gekennzeichnet, daß ein zweiter Funktionsgeber ein Magnetsteller (M1,M2) ist, der den Eingangskreisschalter (6,7) betätigt, wobei eine Schaltkreiskopplung über Schaltstrecken (S2,S3) des Meßbereichsleiters (S) dafür sorgt, daß mindestens ein Eingangskreis (a,b) nur eingeschaltet werden kann, wenn die diesem Eingangskreis (a,b) zugeordnete Meßgröße (A,B) mit der am Meßbereichsschalter (S) eingestellten Meßgröße (A,B) übereinstimmt.

13. Multimeter nach Anspruch 12, dadurch gekennzeichnet, daß der zweite Funktionsgeber (M1,M2) einen elektromagnetischen Antrieb mit vorzugsweise bistabilem, durch Ein- und Ausschaltimpulse auslösbarem Stellungswechsel besitzt, und dieser außer dem Eingangskreisschalter (6,7) auch ein Arretierelement (Ar1,Ar2) betätigt, oder hierzu ein weiterer Magnetsteller dient, und das Arretierelement (Ar1,Ar2) bei Betätigung den Meßbereichsschalter (S) so arretiert, daß ein Umschalten auf eine andere Meßgröße nicht möglich ist, wobei das Arretierelement (Ar1,Ar2) nur aktiviert wird, wenn die am Meßbereichsschalter (S) eingeschaltete Meßgröße (A,B) mit der dem Eingangsanschluß (1,2) zugeordneten Meßgröße (A,B) übereinstimmt.

14. Multimeter nach Anspruch 7, dadurch gekennzeichnet, daß ein von Hand betätigbarer Eingangskreisschalter (8) mit einem in einem Hilfkreis (H5) liegenden Hilfskreisschalter (HS5) gekoppelt ist, und beide Schalter von einer Nullstellung (0) aus, je nach Schaltrichtung, auf eine andere Meßgröße (A,B) schaltbar sind, wobei der Hilfskreisschalter (HS5) beim Einschalten einer Meßgröße (A,B) soweit vorauseilt, daß ein im Hilfskreis (H5) liegender Magnetsteller (M3) über eine Arretierung (Ar3) den von Hand betätigbaren Eingangskreisschalter (8) gegen Einschalten sperrt, sofern der Meßbereichsschalter (S) auf einer anderen Meßgröße (A,B) steht als über den Eingangskreisschalter (8) eingestellt werden soll.

15. Multimeter nach Anspruch 2, dadurch gekennzeichnet, daß die Arretierungsvorrichtung die Arretierung der Schalter (S,9) in Abhängigkeit vom Eingangssignal (Ue) des Multimeters auslöst und die Arretierung vorzugsweise nur solange aufrecht erhalten wird, solange ein Eingangssignal (Ue) mit einem Mindestpegel meßbar ist.

## Claims

1. Multimeter for selective measurement of different measurement variables (A, B) whose measurement signals are detected by the multimeter via different input circuits (a, b) which are each assigned to a specific measurement variable (A, B), and in the case of which the preselection of a specific measurement variable (A, B) is carried out with the aid of a measurement range switch (S) and an input circuit switch (6 to 9) is inserted into at least one of the input circuits (a, b), which input circuit switch must additionally be switched on or switched over independently of the measurement variable preselection made with the aid of the measurement range switch (S), in order that the applied measurement signal reaches the input circuit (a, b) associated with the preselected measurement variable (A, B), characterized in that a non-rigid coupling device (H, H1, H2, 9b, 10b) between the input circuit switch (6 to 9) and the measurement range switch (S) ensures that the input circuit switch (6 to 9) can be moved only into a switched-on position of the type which corresponds, in terms of the measurement variable (A, B) which is preselected by the associated input circuit (a, b), with the measurement variable (A, B) set on the measurement range switch (S).

2. Multimeter according to Claim 1, characterized in that at least one of the switch positions of the input circuit switch (6-9) and/or of the measurement range switch (S) is locked in such a manner that switching over to a different measurement variable (A, B) is possible only by releasing a locking device (9c, 10c, Ar1-Ar4).

3. Multimeter according to Claim 2, characterized in that the locking device is constructed with mechanical components of which a first locking element (9c), preferably a locking pin, engages in a second locking element (10c), preferably a locking groove, on a moving part (10), which makes the switching over possible, of the respective switch (S, 9) and thus prevents switching over to an impermissible measurement variable (A, B).

4. Multimeter according to at least one of the preceding claims, characterized in that the input circuit switch (9) is designed as an input circuit manual switch and is located in the region of action of a moving part (10) of the measurement range switch (S), preferably of a switch wheel (10), and the first locking element (9c) is constructed on the moving part (9a) of the input circuit manual switch (9) and makes it possible to act on a second locking element (10c), which is constructed on the moving part (10) of the measurement range switch (S).

5. Multimeter according to Claim 3, characterized in that the input circuit manual switch (9) is designed as a combined rotary and push switch which can assume at least two different basic positions by rotation, in which it switches on in each case one specific input circuit (a, b) when operated by pushing, and the locking element (9c) can move from the basic position of the input circuit switch (9) into different second locking elements (10c), which are assigned to the measurement variable (A, B), preferably locking grooves, in the moving part (10) of the measurement range switch (S), in such a manner that displacement of the switches (S, 9) to another measurement variable is possible only when the input circuit switch (9) is switched off.

6. Multimeter according to Claim 3, characterized in that the first and second locking elements (9c, 10c) also act as coupling elements and, when the lock is released, no coupling exists any longer either and the position or type of the first locking elements (9c) is coded with respect to the position or type of the second locking elements such that mutual engagement and thus switching-on of the input circuit switch is possible only when both switches (S, 9) are set to the same measurement variable (A, B) but it is not possible to switch over when the input circuit switch (9) is switched on, preferably, in that at least one eccentrically arranged first locking element (9c), which is designed as a pin, ensures positioning which changes as a function of the measurement variable (A, B, C) and is opposite these second locking elements (10c), which are designed as grooves, such that the pin can engage in the associated groove only if the position corresponds.

7. Multimeter according to Claim 1 or 2, characterized in that the coupling device is designed with electrical circuits and that the measurement range switch (S) has at least one switching path (S1-S3) via which at least one auxiliary circuit (H1-H5) is routed, in such a manner that, when the auxiliary circuit (H1-H5) is switched on, a fixed assignment, which is dependent on the switch position of the measurement range switch (S), with respect to a specific input circuit (a, b) and thus with respect to a specific measurement variable (A, B) results, and at least one function transmitter (M1-M4, Su) is located in the auxiliary circuit (H1-H5) and is activated on operation by closing the auxiliary circuit (H1-H5).

8. Multimeter according to Claim 7, characterized in that each measurement variable (A, B) is assigned an auxiliary circuit switch (HS3-HS5) whose switch position is coupled to the switch position of the input circuit switch (6-8).

9. Multimeter according to at least one of the preceding claims, characterized in that different input circuits (a, b) are routed via at least one input circuit switch (8), which acts as a changeover switch or on/off switch, to two input connections (1, 2) which are common to a plurality of measurement variables (A, B), or in that different input circuits (a, b) are connected to different input connections (2a, 2b) which in each case correspond to specific measurement variables (A, B), and an input circuit switch (6, 7), which acts as a changeover switch or on/off switch, is inserted into at least one of the input circuits (a, b).

10. Multimeter according to Claim 9, characterized in that a contact mechanism (K1, K2) is integrated in at least one input connection (2a, 2b), the contact path of which contact mechanism (K1, K2) is located in at least one auxiliary circuit (H1-H4) and which makes contact with a measurement lead (L2) on connection and in consequence closes the respective auxiliary circuit (H1-H4).

11. Multimeter according to at least one of the preceding claims, characterized in that a first function transmitter acts as a signal transmitter (Su) which emits a visual or audible warning signal if an input circuit (a, b) is connected to which a measurement variable (A, B) is assigned which is different from the measurement variable (A, B) which is set on the measurement range switch (S).

12. Multimeter according to Claim 7, characterized in that a second function transmitter is a magnetic actuator (M1, M2) which operates the input circuit switch (6, 7), circuit coupling via switching paths (S2, S3) of the measurement range conductor [sic] (S) ensuring that at least one input circuit (a, b) can be switched on only when the measurement variable (A, B) which is assigned to this input circuit (a, b) corresponds with the measurement variable (A, B) which is set on the measurement range switch (S).

13. Multimeter according to Claim 12, characterized in that the second function transmitter (M1, M2) has an electromagnetic drive with a preferably bistable position change which can be triggered by on and off switching pulses and, in addition to the input circuit switch (6, 7), this function transmitter (M1, M2) also operates a locking element (Ar1, Ar2) or a further magnetic actuator is used for this purpose, and the locking element (Ar1, Ar2) locks the measurement range switch (S) on operation such that switching over to a different measurement variable is impossible, the locking element (Ar1, Ar2) being activated only when the measurement variable (A, B) which is selected on the measurement range switch (S) corresponds with the measurement variable (A, B) which is assigned to the input connection (1, 2).

14. Multimeter according to Claim 7, characterized in that an input circuit switch (8) which can be operated manually is coupled to an auxiliary circuit switch (HS5) which is located in an auxiliary circuit (H5), and both switches can be switched from a null position (0) to another measurement variable (A, B) depending on the switching direction, the auxiliary circuit switch (HS5) leading during the selection of a measurement variable (A, B) such that a magnetic actuator (M3) which is located in the auxiliary circuit (H5) inhibits, via a lock (Ar3), the input circuit switch (8) which can be operated manually from being switched on if the measurement range switch (S) is positioned at a different measurement variable (A, B) from that which is intended to be set via the input circuit switch (8).

15. Multimeter according to Claim 2, characterized in that the locking device releases the lock of the switches (S, 9) as a function of the input signal (Ue) of the multimeter, and the locking is preferably maintained only as long as an input signal (Ue) having a minimum level can be measured.

## Revendications

1. Multimètre pour mesurer au choix des grandeurs différentes (A, B) dont les signaux de mesure sont pris en compte par le multimètre en passant par différents circuits d'entrée (a, b) associés chacun à une grandeur à mesurer (A, B) déterminée, la sélection d'une grandeur à mesurer (A, B) déterminée s'effectuant à l'aide d'un sélecteur de gammes de mesure (S) et un sélecteur de circuits d'entrée (6 à 9) qui est inséré dans au moins l'un des circuits d'entrée (a, b) et qui, indépendamment de la sélection de la grandeur à mesurer effectuée à l'aide du sélecteur de gammes de mesure (S), doit en plus être fermé ou commuté afin que le signal de mesure appliqué parvienne dans le circuit d'entrée (a, b) correspondant à la grandeur à mesurer (A, B) présélectionnée, caractérisé par le fait qu'un dispositif de couplage (H, H1, H2, 9b, 10b) non rigide entre le sélecteur de circuits d'entrée (6 à 9) et le sélecteur de gammes de mesure (S) assure que le sélecteur de circuits d'entrée (6 à 9) ne puisse être amené que dans une position de fermeture qui, en ce qui concerne la grandeur à mesurer (A, B) présélectionnée par le circuit d'entrée correspondant (a, b), coïncide avec la grandeur à mesurer (A, B) réglée sur le sélecteur de gammes de mesure (S).

2. Multimètre suivant la revendication 1, caractérisé par le fait qu'au moins l'une des positions du sélecteur de circuits d'entrée (6 à 9) et/ou du sélecteur de gammes de mesure (S) est verrouillée de telle manière qu'une commutation sur une autre grandeur à mesurer (A, B) ne soit possible que par neutralisation d'un dispositif de verrouillage (9c, 10c, Ar1-Ar4).

3. Multimètre suivant la revendication 2, caractérisé par le fait que le dispositif de verrouillage est réalisé avec des composants mécaniques parmi lesquels un premier élément de verrouillage (9c), de préférence un doigt de verrouillage, pénètre dans un second élément de verrouillage (10c), de préférence une rainure de verrouillage, sur une partie mobile (10) du sélecteur respectif (S, 9), permettant la commutation, et empêche ainsi une commutation sur une grandeur à mesurer (A, B) inadmissible.

4. Multimètre suivant au moins l'une des revendications précédentes, caractérisé par le fait que le sélecteur de circuits d'entrée (9) est réalisé sous forme de sélecteur manuel de circuits d'entrée situé dans la zone d'action d'une partie mobile (10) du sélecteur de gammes de mesure (S), de préférence d'une roue de sélecteur (10) et que sur la partie mobile (9a) du sélecteur manuel de circuits d'entrée (9) est formé le premier élément de verrouillage (9c) qui peut entrer en prise avec un second élément de verrouillage (10c) formé sur la partie mobile (10) du sélecteur de gammes de mesure (S).

5. Multimètre suivant la revendication 3, caractérisé par le fait que le sélecteur manuel de circuits d'entrée (9) est réalisé sous forme de sélecteur combiné à rotation et à pression qui, par rotation, peut occuper au moins deux positions de base différentes dans lesquelles il ferme et branche, en cas d'actionnement par pression, respectivement un circuit d'entrée déterminé (a, b), et l'élément de verrouillage (9c) peut, à partir de la position de base du sélecteur de circuits d'entrée (9), pénétrer dans différents seconds éléments de verrouillage (10c), de préférence des rainures de verrouillage, qui sont associés à la grandeur à mesurer (A, B) et disposés dans la partie mobile (10) du sélecteur de gammes de mesure (S), de telle manière que les sélecteurs (S, 9) ne puissent être commutés sur une autre grandeur à mesurer que lorsque le sélecteur de circuits d'entrée (9) est en position ouverte.

6. Multimètre suivant la revendication 3, caractérisé par le fait que les premier et second éléments de verrouillage (9c, 10c) agissent également comme éléments de couplage et lorsque le verrouillage est supprimé, il n'existe pas non plus de couplage, et la position ou le type du premier élément de verrouillage (9c) est codé par rapport à la position ou le type des seconds éléments de verrouillage de telle manière qu'un engagement réciproque et donc une fermeture du sélecteur de circuits d'entrée ne soit possible que lorsque les deux sélecteurs (S, 9) sont réglés sur la même grandeur à mesurer (A, B), et qu'une commutation ne soit pas possible lorsque le sélecteur de circuits d'entrée (9) est fermé, de préférence par le fait qu'au moins un premier élément de verrouillage (9c) réalisé sous forme de doigt et disposé de façon excentrée assure un positionnement alterné, indépendant de la grandeur à mesurer (A, B, C), et des seconds éléments de verrouillage (10c) réalisés sous la forme de rainures se trouvent en regard de ces doigts de manière que les doigts ne puissent pénétrer dans les rainures correspondantes que lorsque leurs positions coïncident.

7. Multimètre suivant la revendication 1 ou 2, caractérisé par le fait que le dispositif de couplage est réalisé avec des circuits électriques et le sélecteur de gammes de mesure (S) comporte au moins un contact (S1-S3) par lequel passe au moins un circuit auxiliaire (S1-S5), de telle manière que lorsque le circuit auxiliaire (H1-H5) est fermé, il s'établit un association fixe, dépendant de la position du sélecteur de gammes de mesure (S), par rapport à un circuit d'entrée déterminé (a, b) et donc par rapport à une grandeur à mesurer (A, B) déterminée, et dans le circuit auxiliaire (H1-H5) se trouve au moins un générateur de fonctions (M1-M4, Su) qui est activé lors de l'actionnement par fermeture du circuit auxiliaire (H1-H5).

8. Multimètre suivant la revendication 7, caractérisé par le fait qu'à chaque grandeur à mesurer (A, B) est associé un interrupteur de circuit auxiliaire (HS3-HS5) dont la position est couplée avec la position du sélecteur de circuits d'entrée (6-8).

9. Multimètre suivant au moins l'une des revendications précédentes, caractérisé par le fait que différents circuits d'entrée (a, b) sont reliés par au moins un sélecteur de circuits d'entrée (8) agissant en tant que commutateur ou d'interrupteur à deux connexions d'entrée (1, 2) communes à plusieurs grandeurs à mesurer (A, B) ou que des circuits d'entrée (a, b) différents sont reliés à des connexions d'entrée (2a, 2b) différentes qui correspondent respectivement à des grandeurs à mesurer (A, B) déterminées et au moins l'un des circuits d'entrée (a, b) contient un sélecteur de circuits d'entrée (6, 7) agissant en tant que commutateur ou interrupteur.

10. Multimètre suivant la revendication 9, caractérisé par le fait qu'à au moins une connexion d'entrée (2a, 2b) est intégré un contacteur (K1, K2) dont le contact se trouve dans au moins un circuit auxiliaire (H1-H4) et qui, lors de la connexion d'une ligne de mesure (L2), est actionné et ferme ainsi le circuit auxiliaire (H1-H4) correspondant.

11. Multimètre suivant au moins l'une des revendications précédentes, caractérisé par le fait qu'un premier générateur de fonctions agit comme émetteur de signaux (Su) qui émet un signal avertisseur optique ou acoustique lors de la connexion d'un circuit d'entrée (a, b) auquel est associé une grandeur à mesurer (A, B) autre que la grandeur à mesurer (A, B) réglée sur le sélecteur de gammes de mesure (S).

12. Multimètre suivant la revendication 7, caractérisé par le fait qu'un deuxième générateur de fonctions est un actionneur magnétique (M1, M2) qui actionne le sélecteur de circuits d'entrée (6, 7), un couplage de circuit assurant, en passant par des contacts (S1, S2) du sélecteur de gammes de mesure (S), qu'au moins un circuit d'entrée (a, b) ne puisse être branché que lorsque la grandeur à mesurer (A, B) associée à ce circuit d'entrée (a, b) coïncide avec la grandeur à mesurer (A, B) réglée sur le sélecteur de gammes de mesure (S).

13. Multimètre suivant la revendication 12, caractérisé par le fait que le deuxième générateur de fonctions (M1, M2) comprend une commande électromagnétique avec changement de position de préférence bistable, qui est déclenchable par des impulsions de fermeture et de coupure et qui actionne, outre le circuit d'entrée (6, 7), également un élément de verrouillage (Ar1, Ar2), ou cela est assuré par un autre actionneur magnétique, et l'élément de verrouillage (Ar1, Ar2) est verrouillé, en cas d'actionnement du sélecteur de gammes de mesure (S), de manière qu'une commutation sur une autre grandeur à mesurer ne soit pas possible, l'élément de verrouillage (Ar1, Ar2) n'étant activé que lorsque la grandeur à mesurer (A, B) sélectionnée sur le sélecteur de gammes de mesure (S) coïncide avec le grandeur à mesurer (A, B) associée à la connexion d'entrée (1, 2).

14. Multimètre suivant la revendication 7, caractérisé par le fait qu'un sélecteur de circuits d'entrée (8) actionnable à la main est couplé avec un sélecteur de circuits auxiliaires (HS5) situé dans un circuit auxiliaire (H5), et que les deux sélecteurs sont commutables d'une position zéro (O), selon le sens de commutation, sur une autre grandeur à mesurer (A, B), le sélecteur de circuits auxiliaires (HS5) étant, lors de la commutation sur une grandeur à mesurer (A, B), en avance de manière qu'un actionneur magnétique (M3) situé dans le circuit auxiliaire (H5) bloque, par un verrouillage (Ar3), le sélecteur de circuits d'entrée (8) actionnable à la main, pour empêcher la fermeture lorsque le sélecteur de gammes de mesure (S) se trouve sur une grandeur à mesurer (A, B) différente de celle réglée par le sélecteur de circuits d'entrée (8).

15. Multimètre suivant la revendication 2, caractérisé par le fait que le dispositif de verrouillage déclenche le verrouillage des sélecteurs (S, 9) en fonction du signal d'entrée (Ue) du multimètre et que le verrouillage est maintenu de préférence uniquement tant qu'un signal d'entrée (Ue) ayant un niveau minimal est mesurable.
